## Europäisches Patentamt

(19) **European Patent Office**

**Office européen des brevets**

(11) Publication number : **0 438 867 B1**

## (12) EUROPEAN PATENT SPECIFICATION

(45) Date of publication of patent specification :
**25.10.95 Bulletin 95/43**

(51) Int. Cl.$^6$ : **H03M 3/02, H03L 7/197**

(21) Application number : **90312888.2**

(22) Date of filing : **27.11.90**

(54) **Multiple-modulator fractional-N divider.**

(30) Priority : **23.01.90 US 469656**

(43) Date of publication of application :
**31.07.91 Bulletin 91/31**

(45) Publication of the grant of the patent :
**25.10.95 Bulletin 95/43**

(84) Designated Contracting States :
**DE FR GB IT**

(56) References cited :
**EP-A- 0 308 194**
**EP-A- 0 328 318**
**WO-A-86/05046**
**US-B- 4 609 881**

(56) References cited :
**1989 IEEE SYMPOSIUM ON CIRCUITS AND SYSTEMS, MAY 8-11, vol. 1/3, NEW YORK, USA pages 246 - 249 ; MIKE REBESCHINI ET AL.: 'A HIGH RESOLUTION CMOS SIGMA-DELTA A/ D CONVERTER WITH 32O KHZ OUTPUT RATE. '**

(73) Proprietor : **Hewlett-Packard Company**
**Mail Stop 20 B-O,**
**3000 Hanover Street**
**Palo Alto, California 94304 (US)**

(72) Inventor : **Miller, Brian M.**
**S 1307 Greenridge**
**Liberty Lake, Washington 99019 (US)**

(74) Representative : **Colgan, Stephen James et al**
**CARPMAELS & RANSFORD**
**43 Bloomsbury Square**
**London WC1A 2RA (GB)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

Background of the Invention

The present invention relates generally to signal synthesizers and more particularly to frequency synthesizers utilizing fractional-N techniques to provide an output frequency which is related to a reference frequency by a rational divisor N.F where N is an integer portion and F is a fractional portion of the divisor.

A frequency synthesizer is a device which generates an output signal having a frequency which is an exact multiple of a reference frequency, the accuracy of the output signal frequency typically determined by the accuracy and stability of the referenced frequency source. Frequency synthesizers utilizing a phase lock loop (PLL) to provide an output signal having a selectable, precise and stable frequency are well known in the art. Typically a PLL includes a tunable oscillator such as a voltage controlled oscillator (VCO), the output of which is locked to a known reference signal by means of a phase comparator. The phase comparator generates an output voltage or current that is proportional to the phase difference between the known reference signal and the VCO output signal. The output of the phase comparator is coupled back to the input of the VCO to tune and lock the VCO to a desired frequency. This forces the VCO output to have the same frequency as the reference signal. To provide a frequency synthesizer having a variable output frequency, a divisor circuit is interposed between the output of the VCO and the phase comparator, wherein the VCO output frequency is divided by a selectable divisor before it is compared with the reference frequency. The VCO output frequency will then be an exact multiple of the referenced frequency. If the divisor, N, is an integer, the smallest increment in the VCO output frequency value is necessarily equal to the magnitude of the reference frequency itself. Thus, in order to provide a frequency synthesizer having a small step size between adjacent output frequencies, a very low reference frequency is required. However use of a very low reference frequency introduces unacceptable effects such as limited frequency range and a long settling time for the PLL.

A technique known as fractional-N synthesis is often utilized to synthesize output signals having a frequency which is a rational multiple of the reference signal frequency. Typically, frequency divider circuits are implemented in such a manner that they only divide by an integer value and it is necessary to simulate fractional division by changing the divisor integer value temporarily during the course of a division cycle. The non-integer division ratios are realized by dividing by N + 1, for example, instead of N on a proportional number of division cycles to provide an average division ratio which approximates the desired rational divisor number. For example, if the desired rational divisor is taken to be N.1, the divide value will be N for nine division cycles and N + 1 for the tenth division cycle. Thus, when averaged over ten cycles the division factor equals N.1 and the VCO output frequency will be N.1 times the reference frequency. Such a fractional-N technique is disclosed in U.S. Patent No. 3,928,813 issued to Charles A. Kingford Smith on December 23, 1975.

While such fractional-N dividers are widely used for frequency synthesis, switching between different divisor values results in undesirable phase error or phase "jitter" near the desired carrier frequency. When switching between adjacent integer divide ratios, the average divide ratio is correct, but the instantaneous divide ratio is never correct which results in phase error at the phase detector output. This phase error phase modulates the VCO to generate the spurious signals known as phase jitter. Typically, to alleviate the jitter problem a phase error correctional signal is generated and summed into the PLL. The technique, known as phase interpolation, is limited by the ability to precisely generate the required correction signal. For example, to achieve a reduction in the jitter to -70dBc requires a phase interpolation signal having less than 0.03 percent error. It is extremely difficult to generate a correctional signal having the necessary degree of accuracy and such circuitry is complex and expensive and limits the jitter performance of this fractional-N technique.

U.S. Patent No. 4,609,881 granted to John N. Wells on September 2, 1986 describes a fractional-N frequency synthesizer wherein the phase noise caused by the step change in divisor value is removed by altering the divisor value in accordance with the terms of a plurality of sequences each of which sums to zero and which represents successive rows in a Pascal's triangle. Each sequence is defined by a number of predetermined delays arranged in a predetermined order. Each predetermined sequence periodically alters the divisor value a predetermined number of times by predetermined values such that resulting phase differences present at the phase comparator sum to zero.

Summary of the Invention

The features of the invention are defined by Claims 1 and 3. A method of fractional-N-synthesis and a fractional-N-synthesiser in accordance with an embodiment of the invention comprises a variable frequency oscillator connected in a phase loop having a selectable output frequency which is a rational multiple of a reference frequency. The output of the variable frequency oscillator is coupled via a variable integer divisor frequency divider to a phase detector where it is compared with a reference frequency. The phase detector generates a control signal which is a function of the phase difference between the frequency divided variable frequency oscillator output and the reference frequency. The control signal is coupled via a loop amplifier and low pass filter to a control input at the variable frequency oscillator to control the frequency of the oscillator and lock the PLL to a selected frequency. A first sigma-delta modulator circuit arranged as a clocked accumulator responsive to a fractional divisor value at its input generates a modulus control signal coupled to the frequency divider to periodically increase the frequency divider integer divisor value on a proportional basis to provide an average divisor value corresponding to a selected oscillator output frequency. A plurality of additional sigma-delta modulator cells are connected in cascade fashion to the first sigma-delta modulator circuit and generate a zero-mean modulation signal which is summed with the modulus control signal and periodically varies the divisor value about its nominal value by a small amplitude, + or -1 for example. An individual sigma-delta modulator cell comprises an integrator which generates an overflow signal coupled via a summer to a differentiator circuit. For each overflow signal generated, the differentiator generates a positive pulse and then a negative pulse on the next clock pulse. The output of the differentiator circuit is coupled to the summer in the preceding modulator cell to be summed with the overflow signal produced by the preceding integrator. The output of the integrator is coupled to the input of the integrator in the next successive sigma-delta modulator cell. The output of the differentiator circuit for the second modulator cell is summed with the overflow output of the first sigma-delta modulator to provide the modulus control signal.

The variations in the frequency divider divisor value produced by the additional sigma-delta modulator cells sum to zero and do not affect the average divisor value, but do alter the instantaneous divisor value and the noise or jitter components of the PLL output signal due to phase modulation of the VCO resulting from the fractional-N technique. The variable frequency oscillator output frequency is an exact multiple of the reference frequency, the multiplier being the average divisor of the loop frequency divider. The variations in the divisor value produce phase error at the phase detector which, in turn, generates spurious noise in the oscillator output signal. The instantaneous variations in the phase error due to the signal generated by the modulator cells produce an increase in the spurious noise content of the oscillator at large offsets from the desired output frequency, but greatly reduce the spurious noise at small offsets from the desired output frequency when compared to conventional (single modulator) fractional-N synthesis. Increasing the number of modulator cells utilized further reduces the spurious noise or jitter near the oscillator output frequency.

The multiple cascaded sigma-delta modulators used in the present invention are implemented in a digital circuit or in software and comprises a simple, iterated cell structure and does not require *a priori* determination of a control sequence. The modulator cell structure is applicable to simple, highly structured hardware or firmware implementations and is much simpler to implement than analog functions of similar complexity. The present invention provides a fractional-N phase locked loop which synthesizes a selectable output frequency having low spurious or jitter noise and which does not require the cost and complexity of generating an analog phase interpolation correction signal.

Brief Description of the Drawing

A fuller understanding of the present invention will become apparent from the following detailed description taken in conjunction with the accompanying drawing which forms a part of the specification and in which:

Figure 1 is a block diagram illustrating a phase lock loop type frequency synthesizer;

Figure 2 is a block diagram illustrating an alternate embodiment of a phase lock loop type frequency synthesizer;

Figure 3a is a conceptual block diagram of a modulator circuit;

Figure 3b is a conceptual block diagram of a quantization model of the modulator circuit shown in Figure 3a;

Figure 3c is a conceptional block diagram of a multiple loop modulator system;

Figure 4 is a diagram illustrating the spectral power density distribution for the quantization noise of the system shown in Figure 3c;

Figure 5a is a conceptual block diagram illustrating a control system model for fractional-N synthesis;

Figure 5b is a conceptual block diagram of a modulator circuit model for the control system shown in Figure 5a;

Figure 5c is a conceptual block diagram illustrating a quantization model of the modulator circuit shown in Figure 5b;

Figure 5d is a conceptual block diagram illustrating a multiple loop modulator system for use in fractional-N synthesis;

Figure 6 is a diagram plotting fractional-N synthesis phase error noise as a function of offset frequency for the system of Figure 5d.

Figure 7a is a block diagram of a single modulator loop for the system shown in Figure 5d;

Figure 7b is a diagram of an accummulator implementation of the modulator circuit of Figure 7a;

Figure 8 is a detailed block diagram illustrating a modulus control circuit according to the principles of the present invention;

Figures 9a and 9b are timing diagrams illustrating the modulus control signal and the instantaneous phase error for an a single modulator fractional divider;

Figure 10 is a diagram illustrating the spurious or jitter noise distribution for a conventional single modulator fractional divider;

Figures 11a and 11b are timing diagrams illustrating the modulus control signal and the instantaneous phase error for a two modulator fractional divider incorporating the modulus control circuit shown in Figure 8; and

Figure 12 is a diagram illustrating the spurious or jitter noise distribution for a two modulator fractional divider.

Detailed Description of the Preferred Embodiment

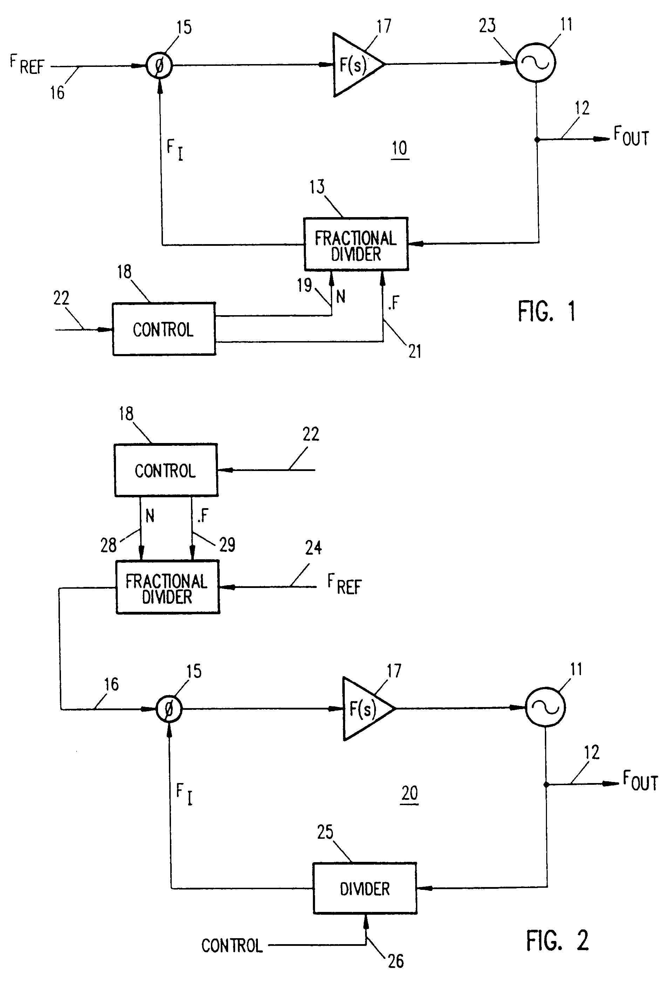

Referring now to Figures 1 and 2, a frequency synthesizer includes a phase lock loop (PLL) comprising a variable frequency oscillator 11 such as a voltage controlled tunable oscillator (VCO), which is controlled by a control signal at an input terminal 23 so as to provide a desired output frequency $F_{out}$ at an output terminal 12. The output of the VCO 11 is also coupled via a variable ratio frequency divider 13 to one input of a phase comparator 15. The frequency divider 13 divides the VCO output frequency, $F_{out}$, by a rational number, which may be an integer N or a fractional value N.F, prior to being compared with a reference frequency ($F_{ref}$) on line 16 at the phase detector 15. Any difference in phase or frequency between the divided VCO output signal and the reference signal applied to the phase detector 15 generates an error or control voltage to be applied at the input terminal 23 of the VCO 11. The output of the phase detector 15 is a voltage that is proportional to the difference in phase between its inputs. Typically an amplifier stage 17 is included between the phase detector 15 and the VCO 11. The amplifier 17 amplifies the error signal representing the phase difference between the reference signal and the VCO output signal and applies it as a tuning voltage to the VCO 11. Typically the loop amplifier 17 will include a low pass filter to remove non-DC components from the phase detector output as well as to define the PLL bandwidth.

The PLL 10 comprises a feedback control system that locks the phase of the VCO output signal $F_{out}$ to the phase of the reference signal $F_{ref}$. The error signal generated by the phase detector 15 controls the output frequency of the VCO 11 so as to keep the frequencies of the input signals $F_I$ and $F_{ref}$ input to the phase detector 15 exactly equal. The output frequency $F_{out}$ of the VCO 11 is an exact multiple of the reference frequency $F_{ref}$. A controller 18 in response to frequency commands on line 22 generates command signals on lines 19 and 21 to set divider 13 to the appropriate divide number to provide a desired output frequency for the VCO 11. The frequency divider 13 may be implemented so as to produce only an integer divisor value thereby producing output frequencies $F_{out}$ which are integral multiples of the reference frequency. In this case the output frequency $F_{out}$ is determined by the value N of the divide number and the step size or interval between output frequencies is determined by the value of the reference frequency. As discussed above, in order to provide a range of output frequencies having small step size it is necessary that the reference frequency be small. Alternatively, well-known techniques, such as the fractional-N techniques referenced above, may be used to provide a large frequency range with small steps between frequencies without the adverse effects encountered when utilizing extremely low reference frequencies.

Fractional-N synthesis utilizes a fractional divisor number N.F to provide output frequencies which are rational multiples of the reference frequency. To achieve the fractional N.F divide value the value of N is periodically altered during a single division cycle so as to simulate a fractional value N.F. For example, to achieve an average divide ratio of N.1 it is necessary to increase the divide number N by 1 for one cycle out of every 10 cycles of the reference signal frequency, $F_{ref}$.

The actual implementation of a variable ratio or variable modulus divider circuit is a function of the type of divider utilized. Typically, frequency dividers are implemented with digital counters, although other well-known methods are also used. Some dividers are constructed in such a manner that they may only divide by a fixed integer ratio. Other dividers may be configured to allow one of several integer divide ratios. Further, there are often restrictions on exactly when the divide ratio may be changed in order to maintain the integrity of the relationship between the frequency of the input and output signal from the divider circuit. Typically, the fractional divider circuit utilized will be a combination of fixed modulus dividers and variable modulus dividers. For example, the fractional divider circuit may comprise a prescaler which is a 6-bit ring counter followed by a divide-by-2 circuit. In normal operation, the ring counter is set up for modulus 5 division and is followed by the divide-by-2 circuit thereby making the divisor equal to 10. The fractional divider circuit is then followed by a variable integer divide-by-N counter. The ring counter modulus may be temporarily reset from 5 to 6 for one cycle and then back to modulus 5 for the subsequent cycle resulting in a divide-by-11 operation which effectively removes one pulse of the VCO output signal or 2 Pi of accumulated phase shift from the input to the divide-by-N counter. Similarly, the ring counter modulus may be changed to 4 for one cycle and then back to modulus 5 for the next cycle resulting in a divide-by-9 operation which effectively adds a pulse of the VCO output signal or 2 Pi of accumulated phase shift to the input of the divide-by-N counter.

Referring again to Figures 1 and 2, the PLL 10 may be configured to include fractional divider 13 having the VCO output signal $F_{out}$ as a input and providing an intermediate frequency signal $F_I$ equal to the frequency of the reference signal $F_{ref}$ to the phase detector 15. Alternatively, as shown in Figure 2, PLL 20 is configured with a divide-by-N circuit 25 having the VCO output frequency $F_{out}$ as an input and providing an intermediate $F_I$ to the one input of the phase detector 15. The divide-by-N circuit 25 may have a fixed integer divide number or it may have a variable integer divide number controlled by controller 18 on line 26. The PLL 20 also includes fractional divider 27 having the reference frequency $F_{ref}$ as an input on line 24 and producing an intermediate reference frequency on line 16 coupled to a second input of the phase detector 15. The variable modulus of fractional divider 27 is controlled by controller 18 on lines 28 and 29. The output of the VCO 11, $F_{out}$, then is an exact rational multiple of the reference frequency $F_{ref}$ wherein the rational multiple is a predetermined combination of the divide ratios of the divider 25 and the fractional divider 27.

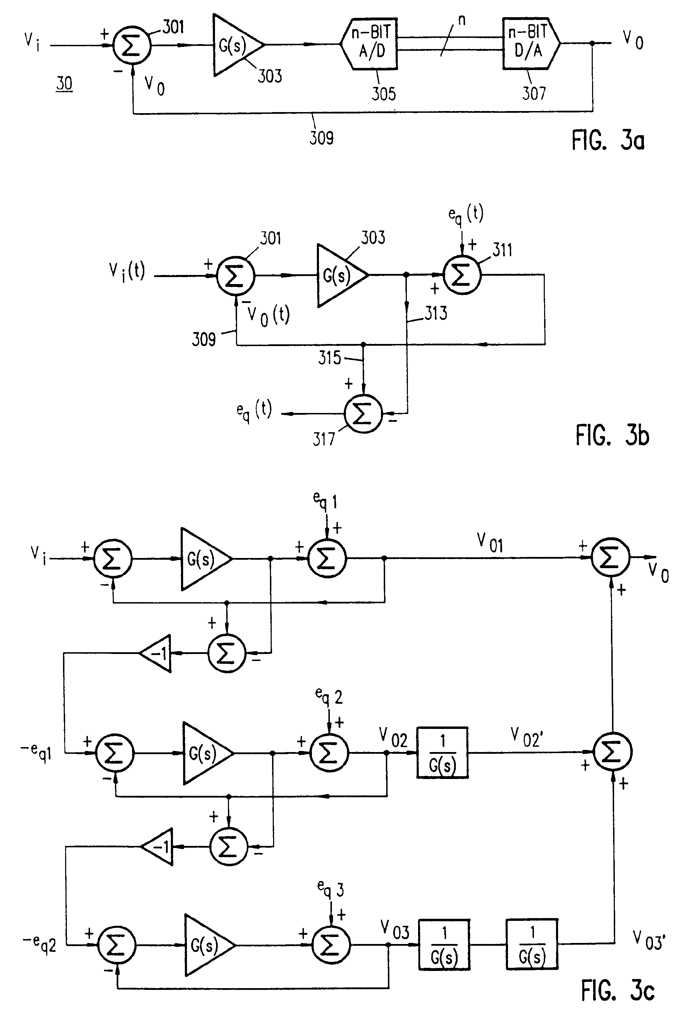

Referring now also to Figures 3a, 3b and 3c, Figure 3a illustrates a conceptual block diagram of a modulator circuit 30 comprising summer block 301, integrating amplifier 303 having a transfer function G(s), an analog-to-digital converter (ADC) 305 and a digital-to-converter (DAC) 307. The output signal $v_o$ is coupled back to a minus terminal at summer 301 on line 309 to be combined with the input $v_i$. If the integrator 303 is an ideal integrator and the ADC resolution is a single bit, then the circuit 30 is known as a sigma-delta modulator. Treating the circuit 30 as a generalized loop filter and assuming that ADC 305 and DAC 307 are ideal with infinite resolution, if sampling effects (sample rate, zero order holds, etc) are ignored, then:

$$v_o/v_i = (G(s)/(1 + G(s))), \quad (1)$$

where s is a LaPlace variable in the continuous time domain.

Considering a finite resolution for ADC 305 and DAC 307 where the input to ADC 305 is sufficiently random, the effect of the analog-to-digital conversion can be remodeled as added quantization noise. The quantization noise is white with

$$\sigma^2 = (LSB)^2/12,$$

where LSB is the least significant bit.

Figure 3b illustrates a block diagram of the original circuit 30 with the analog-to-digital conversion effects modelled by added quantization noise eq(t) at summer block 311. The instantaneous quantization noise is recovered and output by comparing the signals at the input 313 to the ADC 305 and output 315 of the DAC 307 at summer 317. From Figure 3b,

$$v_o/eq(t) = 1/(1 + G(s)). \quad (2)$$

In Figure 3c a multiple loop system comprising three loops, each loop identical to the original circuit 30 with the analog-to-digital conversion errors of each loop replaced by their quantization noise models as shown in Figure 3b. The input signal for the second and third loops is the negative of the quantization noise of the preceding loop. From Figure 3c utilizing equations (1) and (2):

$$v_{o1} = \frac{G(s)}{1 + G(s)} * v_i + \frac{1}{1 + G(s)} * e_{q1} \quad (eq\ 3)$$

$$v_{o2} = \frac{-G(s)}{1 + G(s)} * e_{q1} + \frac{1}{1 + G(s)} * e_{q2} \quad (eq\ 4)$$

$$v_{o2'} = \frac{-1}{1 + G(s)} * e_{q1} + \frac{1}{(1 + G(s))G(s)} * e_{q2} \quad (eq\ 5)$$

$$v_{o3} = \frac{-G(s)}{1 + G(s)} * e_{q2} + \frac{1}{1 + G(s)} * e_{q3} \quad (eq\ 6)$$

$$v_{o3'} = \frac{-1}{(1 + G(s))G(s)} * e_{q2} + \frac{1}{(1 + G(s))G(s)^2} * e_{q3} \quad (eq\ 7)$$

$$v_o = v_{o1} + v_{o2'} + v_{o3'} = \frac{G(s)}{1 + G(s)} * v_i + \frac{1}{(1 + G(s))G(s)^2} * e_{q3} \quad (eq\ 8)$$

If G(s) is an ideal integration,

$$G(s) = 1/s \quad (9)$$

Substituting equation (9) into equation (8),

$$V_o = \left[ \frac{1}{s+1} \right] \cdot \left[ V_i + s^3 e_{q3} \right] . \qquad (10)$$

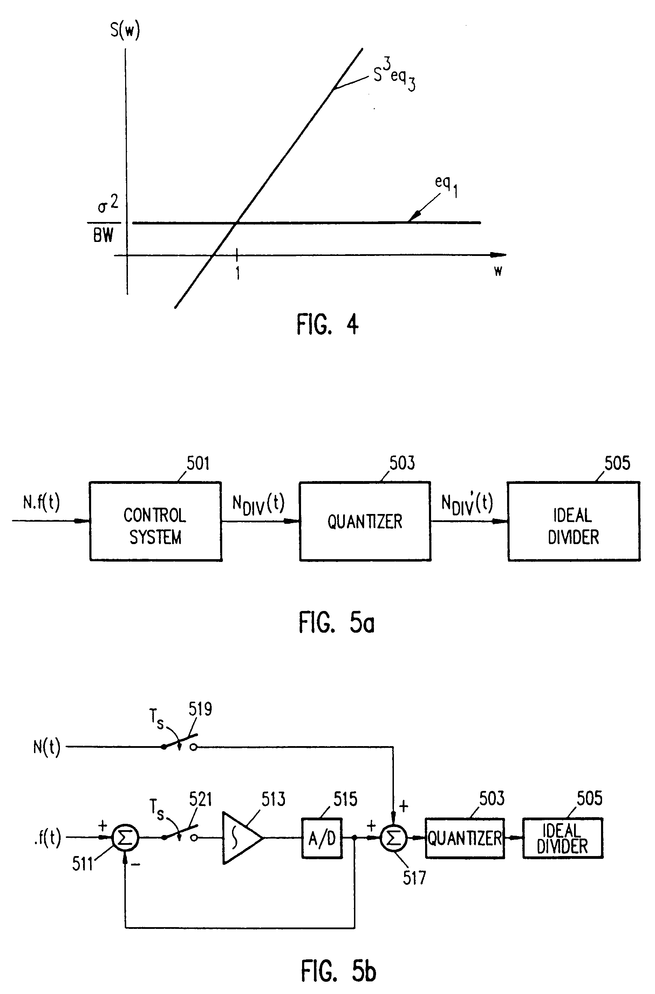

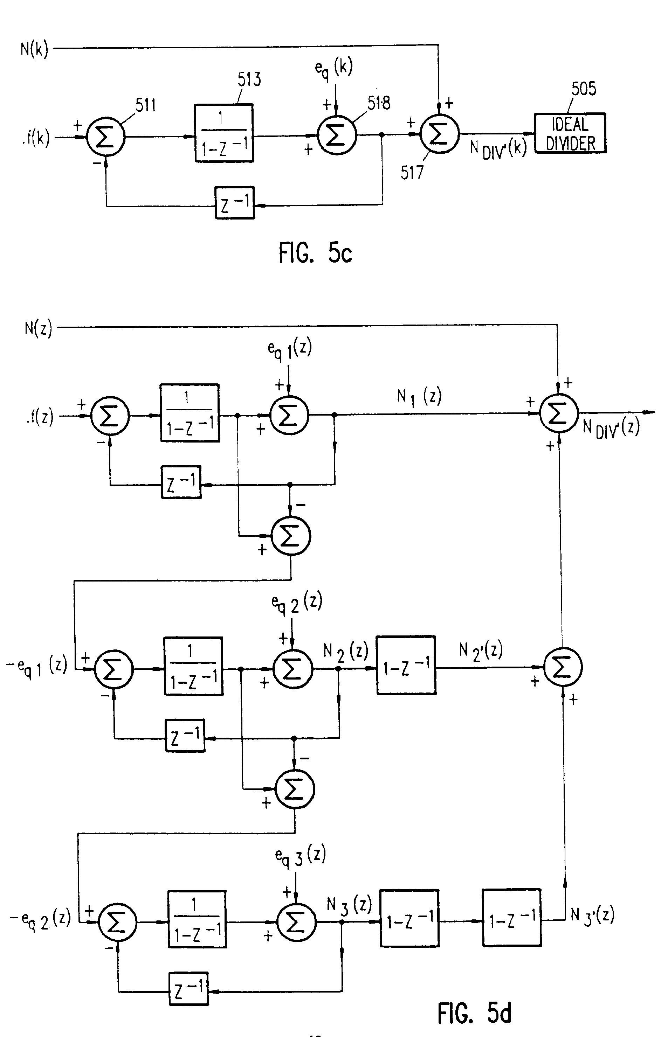

In equation (10), only the quantization noise from the third loop $eq_3$ is present and is shaped by the term $s^3$. Consequently, quantization noise near DC levels is suppressed at the expense of increased noise at large frequencies. Figure 4 illustrates the spectral power density distribution for the quantization noise of the circuit in Figure 3c where the spectral power density, $S(f)$, is a function of the frequency offset f from a signal carrier frequency; e.g., the output signal $F_{out}$ of a frequency synthesizer.

Referring now also to Figures 5a-5d, the fractional-N synthesis may be thought of as a control system 501 in combination with an ideal divider circuit 505 i.e., a divider capable of utilizing non-integer divide ratios preceded by a quantization circuit 503 as shown in Figure 5a. Replacing the control system 501 with the sigma-delta modulator (as shown in Figure 3a) provides a sigma-delta model for fractional-N synthesis comprising summer block 511, an ideal integrator 513 and a 1-bit ADC 515 providing an output signal to the quantization block 503. The input signal to the sigma-delta modulator is the fractional portion .F of the desired rational divide number N.F. The integer portion N of the divide number N.F. is summed with the output of the ADC 515 at summer block 517. The switches 519,521 ($T_s$) reflect the sampled nature of the circuit (i.e., the divide ratio input to the divider circuit 505 is updated every reference frequency cycle). The 1-bit DAC 307 (as shown in Figure 3a) can be omitted if full scale of the ADC 305 is taken to be 1. Converting to the sampled time domain and replacing the ADC with its quantization noise model, the circuit shown in Figure 5c is obtained. The quantization block 503 input has been combined with the quantization noise signal eq(k) on line 518. From Figure 5c,

$$N_{div'}(z) = \frac{1/(1 - z^{-1})}{1 + z^{-1}/(1 - z^{-1})} * (.f(z)) + \frac{1}{1 + z^{-1}/(1 - z^{-1})} * e_q(z) + N(z)$$
$$= N(z) + .f(z) + (1 - z^{-1}) * e_q(z), \quad (eq\ 10)$$

where z is a LaPlace variable in the discrete time domain.

Figure 5d illustrates a multiple loop system comprising three loops, each loop identical to the circuit shown in Figure 5c. The input signal for the second and third loops is the negative of the quantization noise of the preceding loop. From Figure 5d utilizing equation (10),

$$N_1(z) = (1 - z^{-1})eq_1(z) + .f(z); \quad (11)$$
$$N_2(z) = -eq_1(z) + (1 - z^{-1})eq_2(z); \quad (12)$$
$$N_2'(z) = -(1 - z^{-1})eq_1(z) + (1 - z^{-1})^2eq_2(z); \quad (13)$$
$$N_3(z) = -eq_2(z) + (1 - z^{-1})eq_3(z); \quad (14)$$
$$N_3'(z) = -(1 - z^{-1})^2eq_2(z) + (1 - z^{-1})^3eq_3(z) \quad (15)$$
$$N_{div'}(z) = N(z) + N_1(z) + N_2'(z) + N_3'(z) = N.f(z) + (1 - z^{-1})^3eq_3(z) \quad (eq\ 16)$$

In a locked phase-lock loop, the output signal $F_{out} = (N_{div'})*(F_{ref})$; substituting into equation (16),

$$F_{out}(z) = N.F(z) F_{ref} + (1 - z^{-1})^3 F_{ref}\, eq_3(z). \quad (17)$$

The first term of equation 17 is the desired PLL output frequency and the second term represents the frequency noise due to fractional division.

Since $eq_3$ has a variance = 1/12 over a bandwidth of $F_{ref}$, the power spectral density of $eq_3 = 1/(12F_{ref})$. Defining $v(z)$ = frequency fluctuation of $F_{out}(z)$,

$$S_v(z) = \left| (1 - z^{-1})^3 f_{ref} \right|^2 * (1/12 f_{ref}) \quad (eq\ 18)$$
$$= \left| 1 - z^{-1} \right|^6 * f_{ref}/12 \quad (eq\ 19)$$

To convert to phase fluctuation in the z-domain,

$$w(t) = d\phi(t)/dt \qquad \phi(t) = \int w(t)\, dt = 2\pi \int f(t)\, dt$$

utilizing a rectangular integration

$$\Phi(z) = z^{-1}\Phi(z) + W(z)T_s$$
$$\Phi(z) * (1 - z^{-1}) = T_s W(z)$$
$$\Phi(z) = \frac{T_s W(z)}{1 - z^{-1}} = \frac{2\pi T_s V(z)}{1 - z^{-1}} \quad (eq\ 20)$$

Since $T_s - 1/F_{ref}$ = time between samples, substituting into equations (19) and (20),

$$\Phi(z) = \frac{(2\pi)^2}{\left| 1 - z^{-1} \right|^2 f_{ref}^2} * \frac{\left| 1 - z^{-1} \right|^6 f_{ref}}{12}$$

$$= \frac{(2\pi)^2}{12 f_{ref}} \left| 1 - z^{-1} \right|^4 \text{rad}^2/\text{Hz} \quad (eq\ 21)$$

The term $(1 - z^{-1})$ behaves as a differentiator with unity gain at $f = f_{ref}/2\pi$ and generalizing to m loops,

$$L(f) \approx \frac{(2\pi)^2}{12f_{ref}}\left[\frac{f}{f_{ref}/2\pi}\right]^{2(m-1)} rad^2/Hz, \qquad (eq\ 22)$$

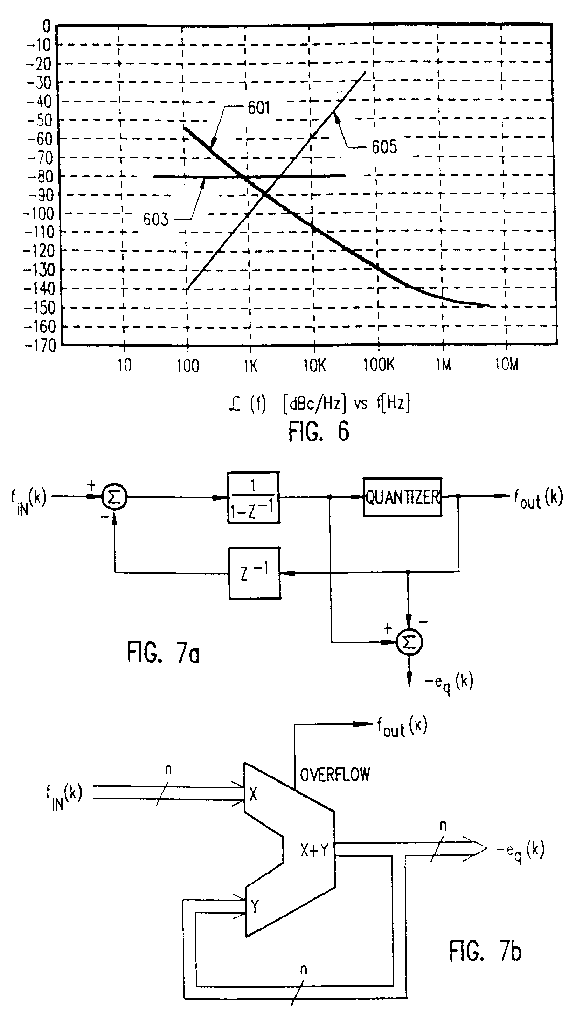

where L(f) represents single side band phase noise. Figure 6 is a plot of the fractional synthesis phase error noise as defined by equation (22) for a fractional-N PLL including a 0.5-1.0 GHz varactor tuned, single band VCO. $F_{ref}$ is 200KHz and the number of loops, m, is 3. The VCO phase noise is shown by curve 601 while the phase detector noise is a flat line 603. The fractional division noise curve 605 intersects the VCO phase noise 601 at an outset (from the carrier frequency, $F_{out}$) greater than where the phase detector phase noise 603 intersects the VCO phase noise curve 601. The phase noise (jitter) due to the fractional division is greater reduced at the carrier frequency, but becomes larger at large offsets (greater than 5KHz in this example) from the carrier frequency. Designing the PLL for narrow bandwidth and utilizing additional filtering outside the PLL bandwidth rejects the fractional division phase noise energy and provides a fractional-N PLL without sophisticated correction circuitry.

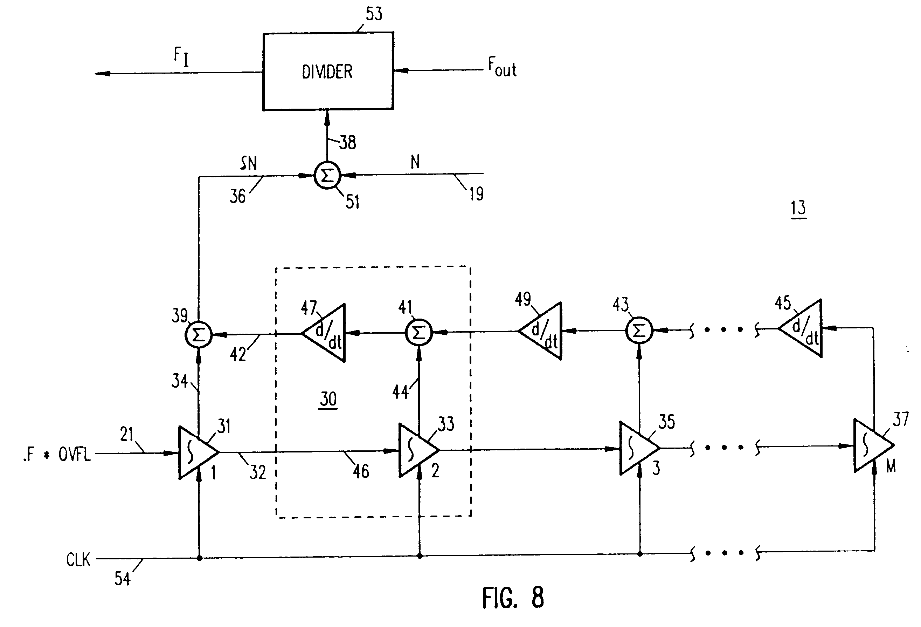

Referring now also to Figures 7a and 7b, the block diagram for each sigma-delta modulator is a moderately complex circuit, but since the function $1/(1-z^{-1})$ is an integration function, the circuit shown in Figure 7a can be implemented with a single, readily available accumulator circuit as shown in Figure 7b. Similarly, the function $(1-z^{-1})$ can be implemented as a differentiator circuit. While the modulator cell 30 has been described and implemented as an integrator circuit, the transfer function G(s) is not restricted to an integration function, but may be any transfer function which provides the desired quantization noise characteristics. Similarly, the single integrator implementation (as shown in Figure 8) is simple to implement and provides good results, but may, for example, be implemented as two or more cascaded integrator circuits.

Referring now also to Figure 8, a detailed block diagram of a multiple modulator fractional divider, fractional divider 13 as shown in Figure 1, for example, according to the principles of the present invention is shown. The fractional divider 13 comprises an integer divide circuit 53 having an integer divide value which is modulated by a modulus control signal on line 38. The modulator control signal on line 38 is provided by the multiple loop modulator circuit shown in Figure 5d. The divider 53 provides an intermediate $F_I$ which is equal to the VCO output frequency $F_{out}$ divided by the integer divide value of the divider 53. The modulus control signal on line 38 comprises the integer divide value N on line 19 provided by controller 18 and a modulation signal δN on line 36 which is derived from the fractional portion .F provided by controller 18 on line 21. The modulus control signal on line 38 modulates the nominal integer value N of the frequency divider 53 to provide an average divide value for the divider 53 of N.F. The fractional portion of the divisor value N.F is coupled to an integrator 31 on line 21 to generate the δ N signal on line 36. A series of cascaded modulator cells 30 are coupled to the output of integrator 31. Each modulator cell 30 is identical and comprises a sigma-delta modulator implemented as an integrator 33, a summer circuit 41 and a differentiator circuit 47. In this example, only three additional modulator cells 30 are illustrated, but additional modulator cells may be provided as required. Each of the integrators 31, 33, 35, 37 has an integration function of $1/(1-z^{-1})$ and is commonly referred to as an accumulator. Similarly each of the differentiator circuits 47, 49, 45 is characterized by differentiation function of $1- z^{-1}$. A new value of δ N on line 36 is computed once per period of the reference clock $F_{ref}$. The clock signal on line 54 has an average frequency greater than or equal to the output frequency of divider 53, $F_I$, and may be obtained directly from the output of divider 53. A clock frequency greater than $F_I$ can be utilized to provide multiple clock cycles in which to perform the mathematical calculations of δ N on line 36. Typically a clock signal having a frequency greater than $F_I$ is obtained by dividing the output frequency of the VCO $F_{out}$. In all cases the modulus control signal on line 38 is updated once per period of the output frequency $F_I$ of divider circuit 53.

In a well-known manner, the value on line 21 is input to the integrator 31 and is added to the value already held in integrator 31 and a new sum is instantly made available on the output line 32 which also represents the input line for integrator 33. When the value held by an integrator or accumulator reaches a predetermined value, labeled "OVFL", it generates an overflow or carry signal on line 34 as an input to summer 39. The overflow signal on line 34 then is summed with any signal which may be on line 42 at the summer 39 to generate the δ N signal on line 36. All of the integrators 31, 33, 35, 37 have the same overflow value, but because the integrators are cascaded together those integrators furthest from the input line 21 will overflow more rapidly than the integrators closer to the input line 21. The fractional portion of the average divide ratio thus obtained is the value represented on input line 21 divided by the value OVFL. For example, in a system where the integrator's overflow at a value of 1000 and a value on the input line 21 is 27, the fractional portion of the divide ratio thus obtained will be 0.027. The overall average divide ratio of the divider 53 will be N.027, where N is the value input to summer 51 on line 19. Therefore the value input to integrator 31 on line 21 is a fractional portion of the average divide ratio, N.F, times the overflow value for the integrator 31, .F∗OVFL.

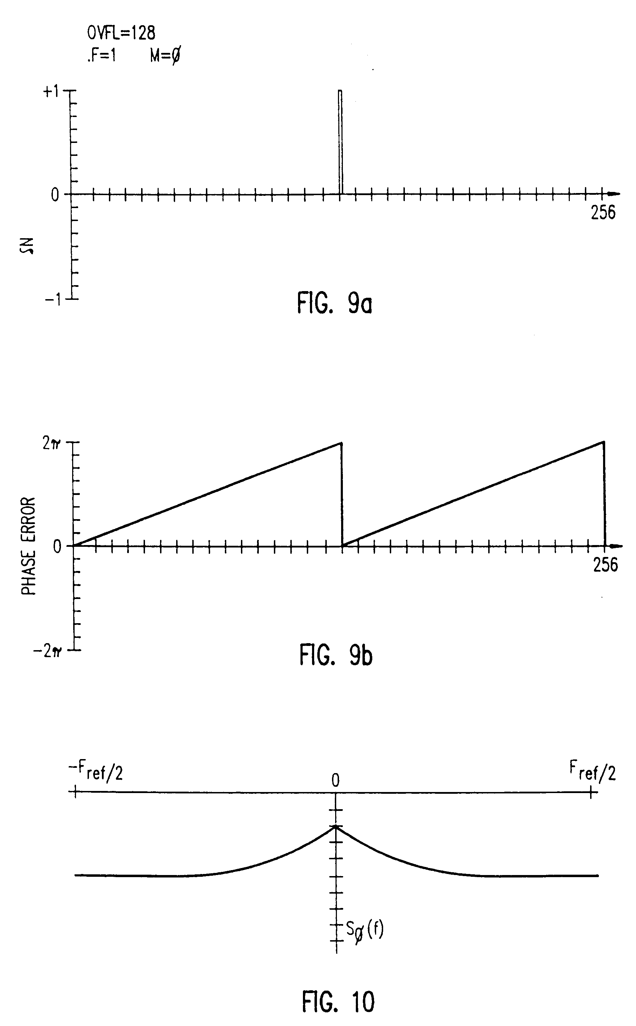

Referring now also to Figures 9a and 9b, consider a fractional divider 13 wherein only one modulator 31 (implemented as integrator 31), and no additional modulator cells, is utilized. If the fractional portion of the desired divide ration is 1/128 and the overflow value for the integrator 31 is 128, then the integrator 31 will generate an overflow or carry signal once every 128 cycles of the clock on line 54. The overflow signal on line 34 will cause a N = 1 signal to be present on line 36 for 1 clock period. Therefore the nominal integer value N of the divisor for divider 53 is increased by 1 for 1 clock period out of every 128 clock periods. Figure 9a illustrates the modulus control signal on line 38 versus time. Figure 9b plots the phase error versus time. A cyclic phase error exists because the fractional divider 13 provides only the correct average divide ratio, not the correct instantaneous divide ratio. Figure 10 is a plot of the power spectral density S(f), where f is the outset frequency, of the spurious noise or jitter resulting from the phase error shown in Figure 9b and exhibits a peak at the carrier or desired VCO output frequency.

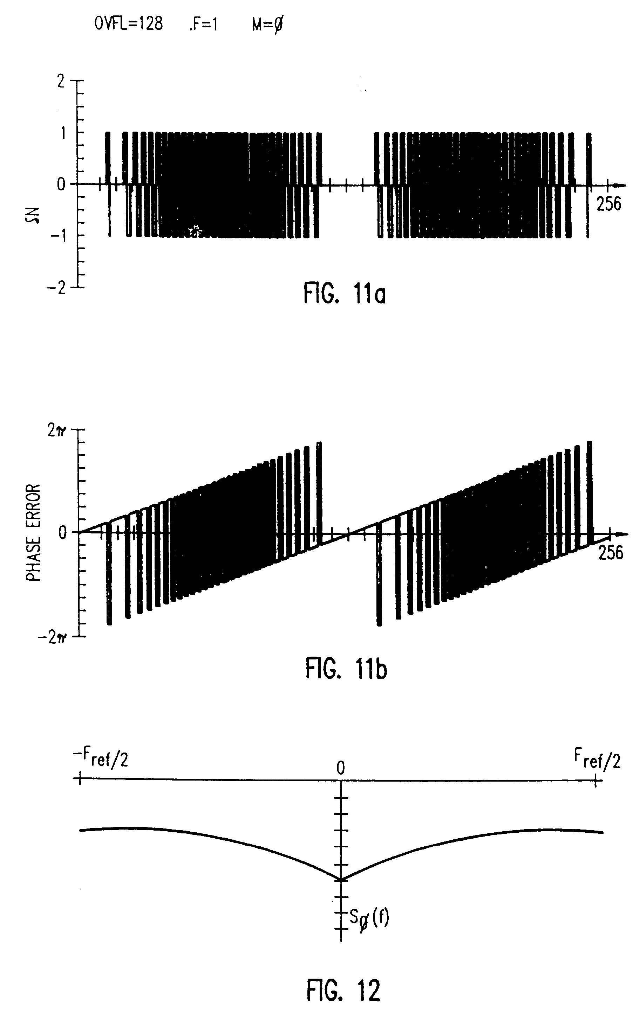

Referring now to Figures 11a, 11b and 12, the same data is plotted for a fractional divider circuit 13 including one additional modulator circuit 30 wherein the input 46 of integrator 33 is connected to the output 32 of integrator 31. The overflow output of integrator 33 is coupled on line 44 to differentiator 47 via summer 41. The output of the differentiator 47 is coupled to summer 39 on line 42. For each overflow or carry signal generated by integrator 33, differentiator 37 will generate a positive output pulse on the same clock pulse as integrator 33 produced the carry signal and will produce a negative pulse on the next following clock pulse. Thus the nominal integer value divisor for divider 53 will be increased by one on a first clock pulse and decreased by one on a next subsequent clock pulse producing a net change in the divisor of 0. In the above-described system, if .F = 1 and the overflow value = 128, and assuming that initially both integrators 31, 32 have a value of 0, integrator 31 will generate an overflow signal on the 128th clock pulse. However, integrator 33 will produce overflow signals on the eleventh, twentieth, twenty-fifth, thirtieth, clock pulses etc. Figure 11a plots the change in the modulus control signal on line 38 versus time and Figure 11b plots the instantaneous phase error versus time. A comparison of Figures 9a and 9b and 11a and 11b, respectively, illustrates the effect on the modulus control signal that the extra modulator cell 30 has generated. The average change in the modulus control signal and the phase error due to the modulator cell 30 is 0 while the modulation of the modulus control signal due to integrator 31 provides an average overall divisor ratio for divider 53 of 1/128. Figure 12 illustrates the spectral power density of the spurious noise produced by the phase error. The modulation of the nominal integer divide number produces an increased overall spurious noise content. However, the spurious noise energy is greatly reduced at small offsets from the desired output signal; the crossover point being at approximately $F_{out}$ divided by 6. The spurious noise energy at large offsets may be easily filtered by conventional means to provide a signal having a desired frequency with substantial less jitter noise than that produced by conventional fractional-N synthesis methods.

Although the present invention has been shown and described in connection with certain specific embodiments, it will be readily apparent to those skilled in the art that various changes in form and arrangement may be made without departing from or exceeding the scope of the claims appended hereto.

## Claims

1.    A method of fractional-N-synthesis, the method including:

(a) generating a desired output frequency ($F_{out}$) ;

(b) dividing the output frequency ($F_{out}$) by a divisor (N);

(c) comparing the divided output frequency with a reference frequency ($F_{ref}$) to determine any difference in phase therebetween;

(d) using said phase difference to lock the phase of the output frequency ($F_{out}$) to the phase of the reference frequency ($F_{ref}$) and to keep the divided output frequency and reference frequency precisely equal; and

(e) periodically altering the value of the divisor N during a division cycle, so as to simulate a fractional value (N.F), and to re-distribute, in a desired manner, the frequency spectrum of the quantisation noise associated with said method,

characterised in that:

the divisor value (N) is periodically altered by a process which employs a first sigma delta modulator and a plurality of additional sigma delta modulators connected in cascade with said first sigma delta modulator, said first sigma delta modulator has, as its input, said fractional value (N.F), said first sigma delta modulator generates a modulus control signal and each of said additional sigma delta modulators generates a zero mean modulation signal,

outputs $v_{o1}$, $v_{o2'}$, $v_{o3'}$... from respective sigma delta modulators in said cascade are determined in accor-

dance with the series:

$$v_{o1} = \frac{G(s)}{1 + G(s)} * v_i + \frac{1}{1 + G(s)} * e_{q1}$$

$$v_{o2'} = \frac{-1}{1 + G(s)} * e_{q1} + \frac{1}{(1 + G(s))\,G(s)} * e_{q2}$$

$$v_{o3'} = \frac{-1}{(1 + G(s))\,G(s)} * e_{q2} + \frac{1}{(1 + G(s))\,G(s)^2} * e_{q3}$$

etc...

where $v_{o1}$, $v_{o2'}$, $v_{o3'}$ ... are respective outputs of said sigma delta modulators in said cascade, the output of any subsequent sigma delta modulator being determined in accordance with said series, and where

| | |
|---|---|
| G(s) | is a transfer function for generating said desired quantisation noise spectrum, |
| $v_i$ | is an input to the first sigma delta modulator, |
| $e_{q1}$, $e_{q2}$, $e_{q3}$ | represent added quantisation noise in each respective sigma delta modulator in the cascade. |

2. A method according to claim 1, wherein G(s) is an integration function.

3. A fractional-N-synthesizer comprising:

means for generating a desired output frequency ($F_{out}$) ;

means for dividing the output frequency ($F_{out}$) by a divisor (N);

means for comparing the divided output frequency with a reference frequency ($F_{ref}$) to determine any difference in phase therebetween;

means responsive to said phase difference to lock the phase of the output frequency ($F_{out}$) to the phase of the reference frequency ($F_{ref}$) and to keep the divided output frequency and reference frequency precisely equal; and

means for periodically altering the value of the divisor N during a division cycle, so as to simulate a fractional value (N.F), and to re-distribute, in a desired manner, the frequency spectrum of the quantisation noise associated with the operation of the fractional-N-synthesizer,

characterised in that:

the divisor value (N) is periodically altered by a circuit which employs a first sigma delta modulator and a plurality of additional sigma delta modulators connected in cascade with said first sigma delta modulator, said first sigma delta modulator has, as its input, said fractional value (N.F), said first sigma delta modulator generates a modulus control signal and each of said additional sigma delta modulators generates a zero mean modulation signal,

outputs $v_{o1}$, $v_{o2'}$, $v_{o3'}$ from respective sigma delta modulators in said cascade are determined in accordance with the series:

$$v_{o1} = \frac{G(s)}{1 + G(s)} * v_i + \frac{1}{1 + G(s)} * e_{q1}$$

$$v_{o2'} = \frac{-1}{1 + G(s)} * e_{q1} + \frac{1}{(1 + G(s))\,G(s)} * e_{q2}$$

$$v_{o3'} = \frac{-1}{(1 + G(s))\,G(s)} * e_{q2} + \frac{1}{(1 + G(s))\,G(s)^2} * e_{q3}$$

etc...

where $v_{o1}$, $v_{o2'}$, $v_{o3'}$ ... are respective outputs of said sigma delta modulators in said cascade, the output of any subsequent sigma delta modulator being determined in accordance with said series, and where

| | |
|---|---|
| G(s) | is a transfer function for generating said desired quantisation noise spectrum, |
| $v_i$ | is an input to the first sigma delta modulator, |
| $e_{q1}$, $e_{q2}$, $e_{q3}$ | represent added quantisation noise in each respective sigma delta modulator in the cascade. |

4. A synthesizer according to claim 3, wherein G(s) is an integration function.

**Patentansprüche**

1. Ein Verfahren der Bruch-N-Synthese mit folgenden Schritten:

(a) Erzeugen einer gewünschten Ausgangsfrequenz ($F_{out}$) ;

(b) Teilen der Ausgangsfrequenz ($F_{out}$) durch einen Divisor (N);

(c) Vergleichen der geteilten Ausgangsfrequenz mit einer Referenzfrequenz ($F_{ref}$), um einen beliebigen Phasenunterschied zwischen denselben zu bestimmen;

(d) Verwenden des Phasenunterschiedes, um die Phase der Ausgangsfrequenz ($F_{out}$) auf die Phase der Referenzfrequenz ($F_{ref}$) einzurasten, und um die geteilte Ausgangsfrequenz und die Referenzfrequenz exakt gleich zu halten; und

(e) periodisches Ändern des Wertes des Divisors (N) während eines Teilungszyklus, um einen Bruch-Wert (N,F) zu simulieren und um auf eine gewünschte Art und Weise das Frequenzspektrum des dem Verfahren zugehörigen Quantisierungsrauschens umzuverteilen,

dadurch gekennzeichnet, daß:

der Divisorwert (N) durch ein Verfahren periodisch verändert wird, das einen ersten Sigma-Delta-Modulator und eine Mehrzahl von zusätzlichen Sigma-Delta-Modulatoren verwendet, die mit dem ersten Sigma-Delta-Modulator kaskadenmäßig verbunden sind,

der erste Sigma-Delta-Modulator als seine Eingabe den Bruch-Wert (N,F) hat, wobei der erste Sigma-Delta-Modulator ein Modulus-Steuersignal erzeugt und jeder der zusätzlichen Sigma-Delta-Modulatoren ein Modulationssignal mit einem Mittelwert von Null erzeugt,

Ausgaben $v_{01}$, $v_{02'}$, $v_{03'}$, ... von den entsprechenden Sigma-Delta-Modulatoren in der Kaskade gemäß folgender Reihe bestimmt sind:

$$v_{01} = \frac{G(s)}{1 + G(s)} * v_i + \frac{1}{1 + G(s)} * e_{q1}$$

$$v_{02'} = \frac{-1}{1 - G(s)} * e_{q1} + \frac{1}{(1 + G(s))\, G(s)} * e_{q2}$$

$$v_{03'} = \frac{-1}{(1 + G(s))\, G(s)} * e_{q2} + \frac{1}{(1 + G(s))\, G(s)^2} * e_{q3}$$

usw.

wobei $v_{01}$, $v_{02'}$, $v_{03'}$, ... die entsprechenden Ausgaben der Sigma-Delta-Modulatoren in der Kaskade sind, wobei die Ausgabe eines beliebigen nachfolgenden Sigma-Delta-Modulators gemäß der Reihe bestimmt ist, und wobei

| | |
|---|---|
| G(s) | eine Übertragungsfunktion zur Erzeugung des gewünschten Quantisierungsrauschspektrums ist, |
| $v_i$ | eine Eingabe in den ersten Sigma-Delta-Modulator ist, |
| $e_{q1}$, $e_{q2}$, eq3 | hinzugefügtes Quantisierungsrauschen in jedem entsprechenden Sigma-Delta-Modulator in der Kaskade darstellen. |

2.  Ein Verfahren gemäß Anspruch 1, bei dem G(s) eine Integrationsfunktion ist.

3.  Einen Bruch-N-Synthesizer, der folgende Merkmale aufweist:

eine Einrichtung zum Erzeugen einer gewünschten Ausgangsfrequenz ($F_{out}$);

eine Einrichtung zum Teilen der Ausgangsfrequenz ($F_{out}$) durch einen Divisor (N);

eine Einrichtung zum Vergleichen der geteilten Ausgangsfrequenz mit einer Referenzfrequenz ($F_{ref}$), um einen beliebigen Unterschied in der Phase zwischen denselben zu bestimmen;

eine Einrichtung, die auf die Phasendifferenz anspricht, um die Phase der Ausgangsfrequenz ($F_{out}$) auf die Phase der Referenzfrequenz ($F_{ref}$) einzurasten und um die geteilte Ausgangsfrequenz und die Referenzfrequenz exakt gleich zu halten; und

eine Einrichtung zum periodischen Ändern des Wertes des Divisors (N) während eines Divisionszyklus, um einen Bruch-Wert (N,F) zu simulieren, und um auf eine gewünschte Art und Weise das Frequenzspektrum des dem Betrieb des Bruch-N-Synthesizers zugehörigen Quantisierungsrauschens umzuverteilen,

dadurch gekennzeichnet, daß:

der Divisorwert (N) durch eine Schaltung periodisch geändert wird, die einen ersten Sigma-Delta-Modulator und eine Mehrzahl von zusätzlichen Sigma-Delta-Modulatoren, die kaskadenmäßig mit dem ersten Sigma-Delta-Modulator verbunden sind, verwendet,

der erste Sigma-Delta-Modulator als seine Eingabe den Bruch-Wert (N,F) hat, wobei der erste Sigma-Delta-Modulator ein Modulus-Steuersignal erzeugt und jeder zusätzliche Sigma-Delta-Modulator ein Modulationssignal mit einem Mittelwert von Null erzeugt,

Ausgaben $v_{01}$, $v_{02'}$, $v_{03'}$ der entsprechenden Sigma-Delta-Modulatoren in der Kaskade gemäß der folgenden Reihe bestimmt werden:

$$v_{01} = \frac{G(s)}{1 + G(s)} * v_i + \frac{1}{1 + G(s)} * e_{q1}$$

$$v_{02'} = \frac{-1}{1 + G(s)} * e_{q1} + \frac{1}{(1 + G(s))\, G(s)} * e_{q2}$$

$$v_{03'} = \frac{-1}{(1 + G(s))\, G(s)} * e_{q2} + \frac{1}{(1 + G(s))\, G(s)^2} * e_{q3}$$

usw.

wobei $v_{01}$, $v_{02'}$, $v_{03'}$, ... die entsprechenden Ausgaben der Sigma-Delta Modulatoren in der Kaskade sind, wobei die Ausgabe eines beliebigen nachfolgenden Sigma-Delta-Modulators gemäß der Reihe bestimmt wird, und wobei

| | |
|---|---|
| $G(s)$ | eine Übertragungsfunktion ist, um das gewünschte Quantisierungsrauschspektrum zu erzeugen, |
| $v_i$ | eine Eingabe in den ersten Sigma-Delta-Modulator ist, |
| $e_{q1}$, $e_{q2}$, $e_{q3}$ | hinzugefügtes Quantisierungsrauschen in jedem entsprechenden Sigma-Delta-Modulator in der Kaskade darstellen. |

4. Ein Synthesizer gemäß Anspruch 3, bei dem $G(s)$ eine Integrationsfunktion ist.


**Revendications**

1. Procédé de synthèse par un nombre fractionnaire N, le procédé comportant les étapes consistant à :
    (a) engendrer une fréquence de sortie voulue ($F_{out}$),
    (b) diviser la fréquence de sortie ($F_{out}$) par un diviseur (N),
    (c) comparer la fréquence de sortie divisée à une fréquence de référence ($F_{ref}$) pour déterminer toute différence de phase existant entre celles-ci,
    (d) utiliser ladite différence de phase pour verrouiller la phase de la fréquence de sortie ($F_{out}$) sur la phase de la fréquence de référence ($F_{ref}$) et pour maintenir la fréquence de sortie divisée et la fréquence de référence à un niveau précisément égal, et
    (e) modifier de manière périodique la valeur du diviseur N pendant un cycle de division, de manière à simuler une valeur fractionnaire (N,F) et redistribuer, d'une manière voulue, le spectre de fréquences du bruit de quantification associé audit procédé,
        caractérisé en ce que :
        la valeur (N) du diviseur est modifiée de manière périodique par un procédé qui utilise un premier modulateur sigma-delta et plusieurs modulateurs sigma-delta additionnels reliés en cascade audit premier modulateur sigma-delta,
        ledit premier modulateur sigma-delta reçoit en entrée ladite valeur fractionnaire (N,F), ledit premier modulateur sigma-delta engendre un signal de commande de module et chacun desdits modulateurs sigma-delta additionnels engendre un signal de modulation valant en moyenne zéro,
        les sorties $v_{o1}$, $v_{o2'}$, $v_{o3'}$, ... provenant des modulateurs sigma-delta respectifs, montés dans ladite cascade, sont déterminées conformément aux séries :

$$v_{o1} = \frac{G(s)}{1 + G(s)}\, x\, v_i + \frac{1}{1 + G(s)}\, x\, e_{q1}$$

$$v_{o2'} = \frac{-1}{1 + G(s)}\, x\, e_{q1} + \frac{1}{(1 + G(s))G(s)}\, x\, e_{q2}$$

$$v_{o3'} = \frac{-1}{(1 + G(s))G(s)}\, x\, e_{q2} + \frac{1}{(1 + G(s))G(s)^2}\, x\, e_{q3}$$

où $v_{o1}$, $v_{o2'}$, $v_{o3'}$, ... sont les sorties respectives desdits modulateurs sigma-delta dans ladite cascade, la sortie d'un modulateur sigma-delta consécutif étant déterminée conformément auxdites séries, et où

| | |
|---|---|
| $G(s)$ | est une fonction de transfert pour engendrer ledit spectre voulu de bruit de quantification |
| $v_i$ | est une entrée vers le premier modulateur sigma-delta |
| $e_{q1}$, $e_{q2}$, $e_{q3}$ | représentent les bruits de quantification ajoutés dans chaque modulateur sigma-delta respectif situé dans la cascade. |

2. Procédé selon la revendication 1, dans lequel $G(s)$ est une fonction d'intégration.

3. Synthétiseur par un nombre fractionnaire N comportant :
    des moyens pour engendrer une fréquence de sortie voulue ($F_{out}$),
    des moyens pour diviser la fréquence de sortie ($F_{out}$) par un diviseur (N),

des moyens pour comparer la fréquence de sortie divisée à une fréquence de référence ($F_{ref}$) pour déterminer toute différence de phase existant entre celles-ci,

des moyens réagissant à ladite différence de phase pour verrouiller la phase de la fréquence de sortie ($F_{out}$) sur la phase de la fréquence de référence ($F_{ref}$) et pour maintenir la fréquence de sortie divisée et la fréquence de référence à un niveau précisément égal, et

des moyens pour modifier de manière périodique la valeur du diviseur N pendant un cycle de division, de manière à simuler une valeur fractionnaire (N,F), et redistribuer, d'une manière voulue, le spectre de fréquences du bruit de quantification associé au fonctionnement du synthétiseur par un nombre fractionnaire N,

caractérisé en ce que :

la valeur (N) du diviseur est modifiée de manière périodique par un circuit qui utilise un premier modulateur sigma-delta et plusieurs modulateurs sigma-delta additionnels reliés en cascade audit premier modulateur sigma-delta,

ledit premier modulateur sigma-delta reçoit en entrée ladite valeur fractionnaire (N,F), ledit premier modulateur sigma-delta engendre un signal de commande de module et chacun desdits modulateurs sigma-delta additionnels engendre un signal de modulation valant en moyenne zéro,

les sorties $v_{o1}$, $v_{o2'}$, $v_{o3'}$, ... provenant des modulateurs sigma-delta respectifs montés dans ladite cascade sont déterminées conformément aux séries :

$$v_{o1} \;=\; \frac{G(s)}{1 + G(s)} \times v_i \;+\; \frac{1}{1 + G(s)} \times e_{q1}$$

$$v_{o2'} \;=\; \frac{-1}{1 + G(s)} \times e_{q1} \;+\; \frac{1}{(1 + G(s))G(s)} \times e_{q2}$$

$$v_{o3'} \;=\; \frac{-1}{(1 + G(s))G(s)} \times e_{q2} \;+\; \frac{1}{(1 + G(s))G(s)^2} \times e_{q3}$$

où $v_{o1}$, $v_{o2'}$, $v_{o3'}$, ... sont les sorties respectives desdits modulateurs sigma-delta dans ladite cascade, la sortie d'un modulateur sigma-delta consécutif étant déterminée conformément auxdites séries, et où

G(s)      est une fonction de transfert pour engendrer ledit spectre voulu de bruit de quantification

$v_i$      est une entrée vers le premier modulateur sigma-delta

$e_{q1}$, $e_{q2}$, $e_{q3}$      représentent les bruits de quantification ajoutés dans chaque modulateur sigma-delta respectif situé dans la cascade.

  **4.** Synthétiseur selon la revendication 3, dans lequel G(s) est une fonction d'intégration.

FIG. 1

FIG. 2

FIG. 3a

FIG. 3b

FIG. 3c

FIG. 4

FIG. 5a

FIG. 5b

FIG. 5c

FIG. 5d

16

$\mathcal{L}$ (f)  [dBc/Hz]  vs  f[Hz]

FIG. 6

FIG. 7a

FIG. 7b

17

FIG. 8

OVFL=128
.F=1    M=∅

SN

+1

0

256

−1

FIG. 9a

2π

PHASE ERROR

0

256

−2π

FIG. 9b

$-F_{ref}/2$    0    $F_{ref}/2$

$S_{\phi}(f)$

FIG. 10

OVFL=128    .F=1    M=∅

FIG. 11a

FIG. 11b

FIG. 12